# FASCICULE DE BREVET EUROPEEN

(11) **EP 3 878 011 B1**
(45) Date de publication et mention de la délivrance du brevet: **19.07.2023**
(21) Numéro de dépôt: 19797289.6
(22) Date de dépôt: 05.11.2019
(51) Int. Cl.: H01L 25/07, H01L 25/11, H01L 25/18, H01L 23/13, H01L 23/36, H01L 23/538, H01L 23/58, H01L 23/367, H01L 23/40

(54) **SYSTÈME ÉLECTRONIQUE DE PUISSANCE**
ELEKTRONISCHES LEISTUNGSSYSTEM
ELECTRONIC POWER SYSTEM

(30) Priorité: 06.11.2018 FR 1860229
(43) Date de publication de la demande: 15.09.2021
(73) Titulaire: Institut Polytechnique de Grenoble, 38000 Grenoble (FR)
(72) Inventeur: AVENAS, Yvan, 38330 MONTBONNOT SAINT MARTIN (FR)
(74) Mandataire: Hautier IP
(86) Numéro de dépôt international: PCT/EP2019/080280
(87) Numéro de publication internationale: WO 2020/094663

(56) Documents cités:
- WO-A1-2018/189468
- US-A- 5 424 919
- US-A- 5 705 854
- US-A1- 2005 122 687
- US-A1- 2015 179 611

## Description

### DOMAINE TECHNIQUE DE L'INVENTION

L'invention concerne les systèmes électroniques de puissance. Elle trouve au moins une application particulièrement avantageuse dans le domaine des convertisseurs statiques de puissance.

### ÉTAT DE LA TECHNIQUE

Le document WO 2018/189468 A1 de l'état de la technique divulgue des modules électroniques de puissance comprenant des dissipateurs thermiques. Le document US 5 424 919 A divulgue un dissipateur thermique commun à de différentes modules. Le document US 2015/179611 A1 divulgue des dissipateurs thermiques communs à de différentes modules, et les documents US 5 705 854 A et US 2005/122687 A1 divulguent des dissipateurs thermiques adjacents, mais ces dissipateurs thermiques adjacents sont connectés par un matériau isolant ou par une distance, et ne comprennent pas une connexion électrique latérale conductrice entre les surfaces latérales d'un premier module électrique et un deuxième module électrique.

Un convertisseur électronique de puissance comprend généralement des modules de puissance élémentaires connectés entre eux.

Chaque module de puissance élémentaire comprend des composants de puissance, tels que des transistors (par exemple transistors bipolaires à grille isolée IGBT, de l'anglais « Insulated Gate Bipolar Transistor ») et des diodes, assemblés sous forme de puce afin d'assurer une fonction élémentaire, par exemple une fonction d'interrupteur électronique.

La chaleur produite par les composants de puissance des modules de puissance élémentaire doit être dissipée.

Les modules de puissance élémentaires sont généralement reportés sur un système de refroidissement ou de dissipation thermique.

Un système de refroidissement à air comprenant par exemple des ailettes métalliques soudées sur une embase en aluminium reportée en face arrière du support de puce est une solution standard de l'électronique de puissance.

L'efficacité d'un tel système n'est cependant pas optimale.

Son encombrement et sa masse sont relativement importants.

Une autre solution consiste à utiliser un système de refroidissement liquide afin d'améliorer les échanges thermiques entre le module de puissance et le fluide environnant.

Un tel système nécessite cependant des circuits hydrauliques engendrant un coût supérieur au système de refroidissement à air, et une maintenance plus complexe.

Une autre solution consiste à refroidir les deux faces du composant au sein du module de puissance.

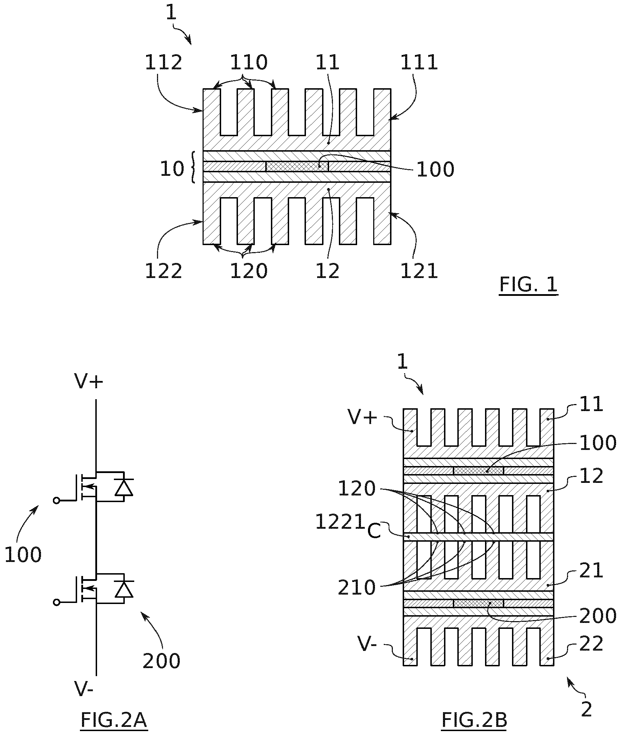

Le composant de puissance est alors intercalé entre un premier dissipateur thermique en regard de sa première face, et un deuxième dissipateur thermique en regard de sa deuxième face, opposée à la première face, tel qu'illustré à la figure 1.

Le premier dissipateur thermique peut en outre être relié à une première électrode, par exemple l'anode, du composant de puissance, de façon à assurer une première connexion électrique, par exemple anodique, au composant de puissance.

Le deuxième dissipateur thermique peut également être relié à une deuxième électrode, par exemple la cathode, du composant de puissance, de façon à assurer une deuxième connexion électrique, par exemple cathodique, au composant de puissance.

Cette solution permet avantageusement de fonctionnaliser les dissipateurs thermiques du module de puissance. Il est dès lors possible d'assembler plusieurs modules de puissance dans une configuration dite « press-pack », sous forme d'un empilement desdits modules de puissance, afin de réaliser des cellules électroniques comprenant au moins deux modules de puissance interconnectés par l'intermédiaire de leurs dissipateurs thermiques.

Un tel assemblage nécessite cependant d'exercer une pression extérieure très importante afin de limiter la résistance thermique de contact entre les dissipateurs thermiques et le boîtier en céramique des modules de puissance interconnectés.

Ce type d'assemblage « press-pack » comprend donc une presse ou un dispositif de pression autour des modules de puissance.

Ce dispositif de pression est généralement encombrant.

Dès lors, un assemblage « press-pack » permet de mettre en série deux modules de puissance, mais n'est pas adapté à la mise en parallèle des modules de puissance.

Cet assemblage induit également des inductances parasites importantes peu compatibles avec la mise en oeuvre de cellules électroniques comprenant des composants de puissance à commutations rapides.

Un objet de la présente invention est de pallier au moins en partie certains des inconvénients mentionnés ci-dessus.

Selon un aspect particulier, un objet de la présente invention est de proposer un système électronique comprenant des modules de puissance en parallèle et/ou en série présentant un système de refroidissement simple et efficace.

Un autre objet de la présente invention est de proposer un système électronique comprenant un assemblage de modules de puissance limitant les inductances parasites.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un premier aspect de l'invention concerne un système électronique comprenant au moins une cellule électronique, ladite au moins une cellule électronique comprenant :
- Un premier module électronique de puissance élémentaire, dit premier module élémentaire,
- Un deuxième module électronique de puissance élémentaire, dit deuxième module élémentaire,

Lesdits premier et deuxième modules élémentaires étant adjacents et connectés entre eux.

Chacun de ces premier et deuxième modules élémentaires comprend :
- au moins un composant de puissance, de préférence intégré sur ou dans un circuit imprimé,
- un premier dissipateur thermique conducteur électrique, dit dissipateur anodique, relié à une première électrode dite anode du composant de puissance, et
- un deuxième dissipateur thermique conducteur électrique, dit dissipateur cathodique, relié à une deuxième électrode dite cathode du composant de puissance.

Les dissipateurs cathodiques présentent chacun une première surface de connexion dite surface centrale cathodique et au moins une deuxième surface de connexion dite surface latérale cathodique.

En outre, les dissipateurs anodiques présentent chacun une première surface de connexion dite surface centrale anodique et au moins une deuxième surface de connexion dite surface latérale anodique.

La connexion des premier et deuxième modules élémentaires adjacents comprend au moins une connexion électrique latérale conductrice entre :
- au moins une parmi les surfaces latérales anodique et cathodique du premier module élémentaire, et
- au moins une parmi les surfaces latérales anodique et cathodique du deuxième module élémentaire.

L'invention est présentée dans les revendications 1-13.

Selon l'invention, les modules de puissance sont connectés latéralement par les surfaces de connexion latérales de leurs dissipateurs thermiques.

Cette première configuration permet de connecter simplement des modules de puissance en parallèle ou en anti-parallèle.

Cette première configuration permet également de connecter des modules de puissance en série, par exemple par retournement à 180° d'un des modules de puissance à connecter.

Les modules de puissance peuvent en outre être connectés verticalement par les surfaces de connexion centrales de leurs dissipateurs thermiques.

Cette deuxième configuration permet de connecter simplement des modules de puissance en série.

Cette deuxième configuration permet également de connecter des modules de puissance en parallèle ou en anti-parallèle, par exemple par retournement à 180° d'un des modules de puissance à connecter.

Un tel système électronique comprenant des modules électroniques connectés selon les première et/ou deuxième configurations précitées permet avantageusement de réaliser différentes structures du domaine de l'électronique de puissance, telles que des cellules de commutation, des hacheurs, ou des onduleurs, possiblement avec des configurations multiniveaux ou entrelacées.

Chaque module élémentaire de puissance étant équipé de deux dissipateurs thermiques, l'efficacité du refroidissement global du système électronique est améliorée.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
- La FIGURE 1 montre un schéma de réalisation physique d'un module électronique de puissance élémentaire selon l'art antérieur ;
- La FIGURE 2A montre un schéma électronique d'une cellule électronique comprenant deux composants de puissance en série ;
- La FIGURE 2B montre un schéma de réalisation physique de la cellule électronique illustrée à la figure 2A selon l'art antérieur ;
- La FIGURE 3A montre un schéma électronique d'une cellule électronique comprenant deux composants de puissance en parallèle ;
- La FIGURE 3B montre un schéma de réalisation physique de la cellule électronique illustrée à la figure 3A selon un mode de réalisation de la présente invention ;
- La FIGURE 3C montre un schéma de réalisation physique de la cellule électronique illustrée à la figure 3A selon un autre mode de réalisation de la présente invention ;
- La FIGURE 3D montre un schéma de réalisation physique de la cellule électronique illustrée à la figure 3A selon un exemple ne faisant pas partie de la présente invention ;
- La FIGURE 4A montre un schéma électronique d'une cellule de commutation ;
- La FIGURE 4B montre un schéma de réalisation physique de la cellule de commutation illustrée à la figure 4A selon un mode de réalisation de la présente invention ;
- La FIGURE 4C montre un schéma de réalisation physique de la cellule de commutation illustrée à la figure 4A selon un autre mode de réalisation de la présente invention ;
- La FIGURE 4D montre un schéma de réalisation physique de la cellule de commutation illustrée à la figure 4A selon un autre mode de réalisation de la présente invention ;
- La FIGURE 5A montre un schéma électronique d'une partie d'un système électronique de conversion multiniveaux correspondant à une mise en série de cellules de commutation ;
- La FIGURE 5B montre un schéma de réalisation physique de la partie du système électronique de conversion multiniveaux illustrée à la figure 5A selon un mode de réalisation de la présente invention ;
- La FIGURE 6A montre un schéma électronique d'un système électronique de conversion de puissance de type hacheur entrelacé, correspondant à une mise en parallèle de cellules de commutation ;
- La FIGURE 6B montre un schéma de réalisation physique du système électronique de conversion de puissance de type hacheur entrelacé illustré à la figure 6A selon un mode de réalisation de la présente invention ;
- La FIGURE 7A montre un schéma de réalisation physique d'un module électronique de puissance élémentaire selon un mode de réalisation de la présente invention ;
- La FIGURE 7B montre un schéma de réalisation physique d'un module électronique de puissance élémentaire selon un autre mode de réalisation de la présente invention ;
- La FIGURE 8A montre un schéma électronique d'une cellule de commutation couplée à une charge par l'intermédiaire d'une inductance ;
- La FIGURE 8B montre un schéma de réalisation physique de l'inductance illustrée à la figure 8A selon un mode de réalisation de la présente invention ;
- La FIGURE 9A montre un schéma de réalisation physique d'un dissipateur thermique selon un mode de réalisation de la présente invention ;
- La FIGURE 9B montre un schéma de réalisation physique d'un dissipateur thermique selon un autre mode de réalisation de la présente invention ;
- La FIGURE 10A montre un schéma de réalisation physique d'une connexion électrique latérale capacitive selon un mode de réalisation de la présente invention ;
- La FIGURE 10B montre un schéma de réalisation physique d'une connexion électrique latérale capacitive selon un autre mode de réalisation de la présente invention ;
- La FIGURE 11A montre un schéma de réalisation physique d'un système électronique selon un mode de réalisation de la présente invention ;
- La FIGURE 11B montre un schéma de réalisation physique en coupe transverse selon le plan A-A indiqué à la FIGURE 11A du système électronique selon le mode de réalisation de la présente invention illustré à la FIGURE 11A ;
- La FIGURE 12 illustre un résultat de simulation thermique effectué sur un demi-module électronique de puissance élémentaire selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

En particulier, les épaisseurs et dimensions des différentes couches et portions des circuits imprimés, des dissipateurs thermiques et des connexions électriques illustrées ne sont pas représentatives de la réalité.

Dans la présente demande de brevet, les notations suivantes sont utilisées :
Pour un module électronique de puissance élémentaire X, on notera :
X0 le circuit imprimé de ce module,
X1, X2 les premier et deuxième dissipateurs thermiques de ce module,
X10, X20 les surfaces centrales de connexion des premier et deuxième dissipateurs thermiques,
X11, X12 des surfaces latérales de connexion du premier dissipateur thermique,
X21, X22 des surfaces latérales de connexion du deuxième dissipateur thermique,
X00, X00_{A}, X00_{B} les composants électroniques de ce module.

Dans la présente demande de brevet, une connexion électrique conductrice entre un dissipateur thermique Xi (i = 1, 2) d'un premier module X et un dissipateur thermique Yj (j = 1, 2) d'un deuxième module Y, est notée :
XiYj_{C}

Dans la présente demande de brevet, une connexion électrique capacitive entre un dissipateur thermique Xi (i = 1, 2) d'un premier module X et un dissipateur thermique Yj (j = 1, 2) d'un deuxième module Y, est notée :
XiYj_{CP}

Dans la présente demande de brevet, une connexion électrique isolante entre un dissipateur thermique Xi (i = 1, 2) d'un premier module X et un dissipateur thermique Yj (j = 1, 2) d'un deuxième module Y, est notée :
XiYjᵢ

La lecture sur la feuille du sens de connexion se fait de gauche à droite, de bas en haut et d'avant en arrière.

Une cellule électronique est notée Cₙ.

Toutes les références de chaque module électronique de puissance élémentaire et/ou de chaque cellule électronique ne sont pas nécessairement reportées sur les dessins par souci de clarté.

Les références des éléments non explicitement référencés sur les dessins peuvent être néanmoins déduites facilement à partir des notations explicitées ci-dessus et de la description détaillée qui suit.

### DESCRIPTION DÉTAILLÉE DE L'INVENTION

Avant d'entamer une revue détaillée de modes de réalisation de l'invention, il est rappelé que l'invention selon son premier aspect comprend notamment les caractéristiques optionnelles ci-après pouvant être utilisées en association:
- Selon un mode de réalisation, la connexion électrique de modules entre les premier et deuxième modules élémentaires adjacents comprend en outre l'une parmi une connexion électrique latérale capacitive et une connexion électrique latérale isolante entre :
   ∘ au moins une autre parmi les surfaces latérales anodique et cathodique du premier module élémentaire, et
   ∘ au moins une autre parmi les surfaces latérales anodique et cathodique du deuxième module élémentaire.
- Selon un mode de réalisation, au moins une surface latérale anodique du premier module élémentaire est connectée à au moins une surface latérale cathodique du deuxième module élémentaire par une connexion électrique latérale conductrice et au moins une surface latérale cathodique du premier module élémentaire est connectée à au moins une surface latérale anodique du deuxième module élémentaire par une connexion électrique parmi une connexion électrique latérale capacitive et une connexion électrique latérale isolante.
- Selon un mode de réalisation, l'au moins un composant de puissance du premier module élémentaire est l'un parmi un premier transistor de puissance et une première diode de puissance, par exemple de type IGBT, et l'au moins un composant de puissance du deuxième module élémentaire est l'un parmi un deuxième transistor de puissance et une deuxième diode de puissance, de sorte que la cellule électronique forme une cellule de commutation.
- Selon un mode de réalisation, le système comprend une pluralité de cellules électroniques adjacentes et connectées entre elles, une cellule électronique de la pluralité de cellules électroniques étant connectée à au moins une cellule électronique adjacente par une connexion électrique de cellules, ladite connexion électrique de cellules comprenant au moins l'une parmi une connexion électrique centrale conductrice, une connexion électrique centrale capacitive et une connexion électrique centrale isolante entre :
   ∘ au moins une parmi les surfaces centrales anodique et cathodique de ladite cellule, et
   ∘ au moins une parmi les surfaces centrales anodique et cathodique de l'au moins une cellule adjacente à ladite cellule.
- Selon un mode de réalisation, la connexion électrique de cellules comprend une connexion électrique centrale conductrice entre :
   ∘ au moins une parmi les surfaces centrales anodique et cathodique de ladite cellule, et
   ∘ au moins une parmi les surfaces centrales anodique et cathodique de l'au moins une cellule adjacente à ladite cellule,
   et l'une parmi une connexion électrique centrale capacitive et une connexion électrique centrale isolante entre :
   ∘ au moins une autre parmi les surfaces centrales anodique et cathodique de la cellule, et
   ∘ au moins une autre parmi les surfaces centrales anodique et cathodique de l'au moins une cellule adjacente à ladite cellule.
- Selon un mode de réalisation, au moins une surface centrale cathodique de la cellule est connectée à au moins une surface centrale anodique de la cellule adjacente par une connexion électrique centrale conductrice et au moins une surface centrale anodique de la cellule est connectée à au moins une surface centrale cathodique de la cellule adjacente par une connexion électrique centrale isolante.
- Selon un mode de réalisation, chaque cellule électronique de la pluralité de cellules électroniques est une cellule de commutation, de sorte que le système forme un sous-ensemble d'un convertisseur de puissance multiniveaux.
- Selon un mode de réalisation, la connexion électrique de cellules comprend en outre au moins une connexion électrique latérale conductrice entre :
   ∘ au moins une parmi les surfaces latérales anodique et cathodique de la cellule, et
   ∘ au moins une parmi les surfaces latérales anodique et cathodique d'au moins une autre cellule adjacente à ladite cellule.
- Selon un mode de réalisation, le système comprend une première cellule électronique, une deuxième cellule électronique, une troisième cellule électronique, une quatrième cellule électronique, lesdites première, deuxième, troisième, quatrième cellules électroniques étant des cellules de commutation, et :
   ∘ Les surfaces centrales anodique et cathodique des dissipateurs thermiques anodique et cathodique reliés entre eux par une connexion électrique latérale capacitive de la première cellule sont respectivement connectées aux surfaces centrales anodique et cathodique des dissipateurs thermiques anodique et cathodique reliés entre eux par une connexion électrique latérale capacitive de la deuxième cellule, par des connexions électriques centrales conductrices,
   ∘ Les surfaces centrales anodique et cathodique des dissipateurs thermiques anodique et cathodique reliés entre eux par une connexion électrique latérale capacitive de la troisième cellule sont respectivement connectées aux surfaces centrales anodique et cathodique des dissipateurs thermiques anodique et cathodique reliés entre eux par une connexion électrique latérale capacitive de la quatrième cellule, par des connexions électriques centrales conductrices,
   ∘ Les surfaces latérales anodique et cathodique des dissipateurs thermiques anodique et cathodique reliés entre eux par une connexion électrique latérale conductrice, situées sur un même côté de la première cellule sont respectivement connectées aux surfaces latérales anodique et cathodique des dissipateurs thermiques anodique et cathodique reliés entre eux par une connexion électrique latérale conductrice, situées sur un même côté de la troisième cellule, par des connexions électriques latérales isolantes,
   ∘ Les surfaces latérales anodique et cathodique des dissipateurs thermiques anodique et cathodique reliés entre eux par une connexion électrique latérale capacitive, situées sur un même côté de la première cellule sont respectivement connectées aux surfaces latérales anodique et cathodique des dissipateurs thermiques anodique et cathodique reliés entre eux par une connexion électrique latérale capacitive, situées sur un même côté de la troisième cellule, par des connexions électriques latérales conductrices,
   ∘ Les surfaces latérales anodique et cathodique des dissipateurs thermiques anodique et cathodique reliés entre eux par une connexion électrique latérale capacitive, situées sur un même côté de la deuxième cellule sont respectivement connectées aux surfaces latérales anodique et cathodique des dissipateurs thermiques anodique et cathodique reliés entre eux par une connexion électrique latérale capacitive, situées sur un même côté de la quatrième cellule, par des connexions électriques latérales conductrices,
   ∘ Les surfaces latérales anodique et cathodique des dissipateurs thermiques anodique et cathodique reliés entre eux par une connexion électrique latérale conductrice, situées sur un même côté de la deuxième cellule sont respectivement connectées aux surfaces latérales anodique et cathodique des dissipateurs thermiques anodique et cathodique reliés entre eux par une connexion électrique latérale conductrice, situées sur un même côté de la quatrième cellule, par des connexions électriques latérales isolantes,
   de sorte que le système forme un convertisseur de puissance de type hacheur entrelacé.
- Selon un mode de réalisation, chaque dissipateur comprend au moins l'un parmi une ailette, une broche et un doigt.
- Selon un mode de réalisation, l'une au moins parmi la connexion électrique latérale capacitive et la connexion électrique centrale capacitive comprend au moins un condensateur.
- Selon un mode de réalisation, le système comprend en outre un dispositif de refroidissement, tel qu'un dispositif de ventilation ou de pompage, configuré pour refroidir chaque dissipateur thermique anodique et cathodique.
- Selon un mode de réalisation, le système comprend en outre au moins un module d'inductance élémentaire comprenant :
   ∘ Une bobine conductrice noyée dans une matrice magnétique présentant une première face et une deuxième face opposée à la première face,
   ∘ un premier dissipateur thermique conducteur électrique sur la première face et relié à ladite bobine conductrice, et
   ∘ un deuxième dissipateur thermique conducteur électrique sur la deuxième face et relié à ladite bobine conductrice.
- Selon un mode de réalisation, les premiers dissipateurs thermiques des premier et deuxième modules élémentaires adjacents forment un seul et même premier dissipateur thermique de cellule. La connexion électrique latérale conductrice entre les premiers dissipateurs thermiques des premier et deuxième modules élémentaires adjacents correspond dès lors à une partie intermédiaire dudit premier dissipateur thermique de cellule. Cette partie intermédiaire peut être située entre une première partie dudit premier dissipateur thermique de cellule, ladite première partie étant associée au premier module élémentaire, et une deuxième partie dudit premier dissipateur thermique de cellule, ladite deuxième partie étant associée au deuxième module élémentaire. Selon ce mode de réalisation, la connexion électrique latérale conductrice entre les premiers dissipateurs thermiques des premier et deuxième modules élémentaires adjacents présente une continuité de matériau avec lesdits premiers dissipateurs thermiques, de sorte que celle-ci soit indissociable desdits premiers dissipateurs thermiques.
- Selon un mode de réalisation, les deuxièmes dissipateurs thermiques des premier et deuxième modules élémentaires adjacents forment un seul et même deuxième dissipateur thermique de cellule. La connexion électrique latérale conductrice entre les deuxièmes dissipateurs thermiques des premier et deuxième modules élémentaires adjacents correspond dès lors à une partie intermédiaire dudit deuxième dissipateur thermique de cellule. Cette partie intermédiaire peut être située entre une première partie dudit deuxième dissipateur thermique de cellule, ladite première partie étant associée au premier module élémentaire, et une deuxième partie dudit deuxième dissipateur thermique de cellule, ladite deuxième partie étant associée au deuxième module élémentaire. Selon ce mode de réalisation, la connexion électrique latérale conductrice entre les deuxièmes dissipateurs thermiques des premier et deuxième modules élémentaires adjacents présente une continuité de matériau avec lesdits deuxièmes dissipateurs thermiques, de sorte que celle-ci soit indissociable desdits deuxièmes dissipateurs thermiques.
- Selon un mode de réalisation, le premier dissipateur thermique du premier module élémentaire et le deuxième dissipateur thermique du deuxième module élémentaire forment un seul et même dissipateur thermique principal de cellule. La connexion électrique latérale conductrice entre le premier dissipateur thermique du premier module élémentaire et le deuxième dissipateur thermique du deuxième module élémentaire correspond dès lors à une partie intermédiaire dudit dissipateur thermique principal de cellule. Cette partie intermédiaire peut être située entre une première partie dudit dissipateur thermique principal de cellule, ladite première partie étant associée au premier module élémentaire, et une deuxième partie dudit dissipateur thermique principal de cellule, ladite deuxième partie étant associée au deuxième module élémentaire. Selon ce mode de réalisation, la connexion électrique latérale conductrice entre le premier dissipateur thermique du premier module élémentaire et le deuxième dissipateur thermique du deuxième module élémentaire présente une continuité de matériau avec lesdits premier et deuxième dissipateurs thermiques, de sorte que celle-ci soit indissociable desdits premier et deuxième dissipateurs thermiques.
- Selon un mode de réalisation, le premier circuit imprimé du premier module élémentaire et le deuxième circuit imprimé du deuxième module élémentaire forment un seul et même circuit imprimé principal. Dans ce mode de réalisation, le circuit imprimé principal comprend des premier et deuxième composants de puissance.

Dans la présente invention, les premier et deuxième dissipateurs thermiques sont dits anodique ou cathodique par souci de clarté. Cette dénomination n'est pas limitative de l'invention. Les dissipateurs anodique et cathodique forment des électrodes. Dans les revendications, ces électrodes sont appelées anode et cathode et peuvent être une anode, une cathode, un émetteur, un collecteur, une source, un drain, etc. Ces électrodes peuvent être interverties selon le sens passant du composant électronique par exemple.

De façon générale dans la présente invention, le dissipateur anodique a de préférence un potentiel électrique plus élevé que le dissipateur cathodique quand l'interrupteur électronique correspondant est ouvert (état bloqué).

Dans la présente invention, on entend par « transistor de type IGBT » un transistor bipolaire à grille isolée (IGBT, de l'anglais « Insulated Gate Bipolar Transistor »).

D'autres architectures de transistors peuvent être utilisées, par exemple mais de façon non limitative :
- un « transistor de type HEMT », qui est un transistor à effet de champ à haute mobilité d'électrons, parfois également désigné par le terme de transistor à effet de champ à hétérostructure,
- un transistor à effet de champ à grille isolée plus couramment nommé MOSFET (acronyme anglais de « Metal Oxide Semiconductor Field Effect Transistor »).

D'autres composants, tels que des thyristors, des thyristors à extinction par gâchette (thyristor GTO ou plus simplement GTO, de l'anglais « Gate Turn-Off » Thyristor), peuvent également être utilisés.

Ces transistors et composants sont bien connus et couramment utilisés dans le domaine de l'électronique de puissance, en particulier pour des convertisseurs statiques de puissance.

On entend par système électronique dans le domaine de l'électronique de puissance des systèmes fonctionnant de préférence avec des courants électriques présentant des intensités comprises entre 10 A et 1000 A, et/ou des tensions électriques comprises entre 10 V et 10000 V, de préférence entre 10 V et 5000 V, et de préférence entre 10 V et 1000 V.

Les convertisseurs de puissance ont pour fonction de convertir un signal électrique en un autre signal électrique. Il existe par exemple des convertisseurs destinés à convertir un courant alternatif en un autre courant alternatif (convertisseurs AC/AC dits gradateurs), des convertisseurs destinés à convertir un courant continu en un autre courant continu (convertisseurs DC/DC dits hacheurs), des convertisseurs destinés à convertir un courant alternatif en un courant continu (convertisseurs AC/DC dits redresseurs), et des convertisseurs destinés à convertir un courant continu en un courant alternatif (convertisseurs DC/AC dits onduleurs).

Le hacheur est un système électronique du domaine de l'électronique de puissance mettant en oeuvre un ou plusieurs interrupteurs électroniques commandés. Il permet notamment de modifier la valeur de la tension moyenne d'une source de tension continue avec un rendement élevé.

Il est donc connecté d'une part à une source de tension continue et d'autre part à une ou plusieurs charges résistives ou inductives. Ces connexions se font au niveau d'un demi-pont ou bras de pont.

Un hacheur peut être constitué d'un ou plusieurs bras de pont.

Le bras de pont peut être constitué par une ou plusieurs cellules de commutation.

Chaque cellule de commutation est formée d'une paire d'interrupteurs (commandés tels que des transistors et/ou non commandés tels que des diodes) reliés entre eux.

Par le jeu de la commutation de ces interrupteurs, le hacheur modifie périodiquement l'interconnexion de la source de tension et de la charge.

La cellule de commutation doit respecter les règles fondamentales d'interconnexion des sources suivantes :
Une source de tension ne doit pas être court-circuitée mais elle peut être ouverte.

Une source de courant ne doit pas être ouverte mais elle peut être court-circuitée.

Il faut donc que l'état des interrupteurs de la cellule de commutation soit complémentaire de façon à respecter les règles d'interconnexion.

Pour assurer cette commutation complémentaire, les interrupteurs peuvent chacun être commandés par un circuit de commande ou « gate driver » selon la terminologie anglo-saxonne.

La vitesse de commutation de ces interrupteurs électroniques peut cependant être limitée par les inductances parasites et/ou les capacités parasites du système électronique. La fréquence de commutation du système électronique peut dès lors être limitée.

Selon l'invention, le système électronique est constitué de plusieurs modules élémentaires comprenant chacun des composants de puissance assurant en particulier une ou des fonctions d'interrupteur électronique.

Le système est donc avantageusement modulaire et permet de réaliser de nombreuses structures de convertisseurs statiques, tels qu'une cellule de commutation, un convertisseur multiniveaux, un hacheur entrelacé.

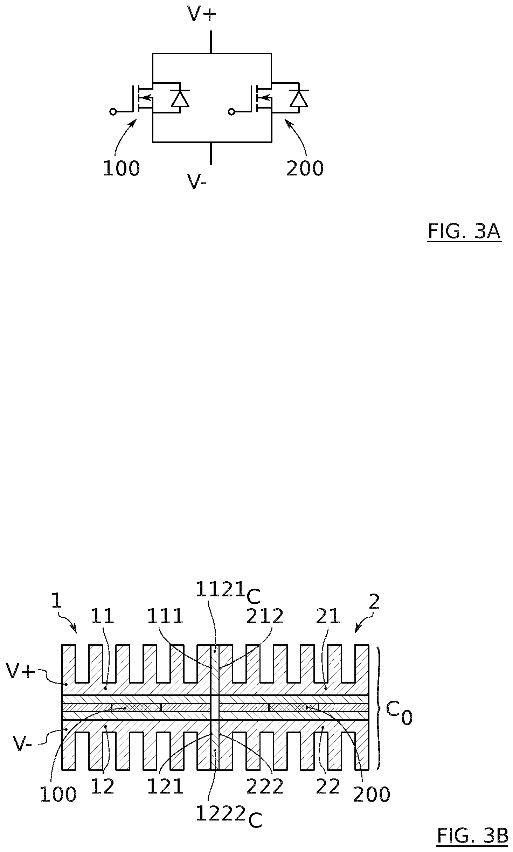

Le principe de modularité du système électronique selon l'invention est illustré aux figures 2B et 3B.

Chaque module élémentaire 1, 2 comprend au moins un composant de puissance 100, 200 intégré de préférence sur un circuit imprimé 10, 20, un premier dissipateur thermique 11, 21 et un deuxième dissipateur thermique 12, 22.

La description qui suit d'un module élémentaire 1 tel qu'illustré à la figure 1 est valable pour les autres modules élémentaires du système électronique selon l'invention en ce qui concerne les caractéristiques communes.

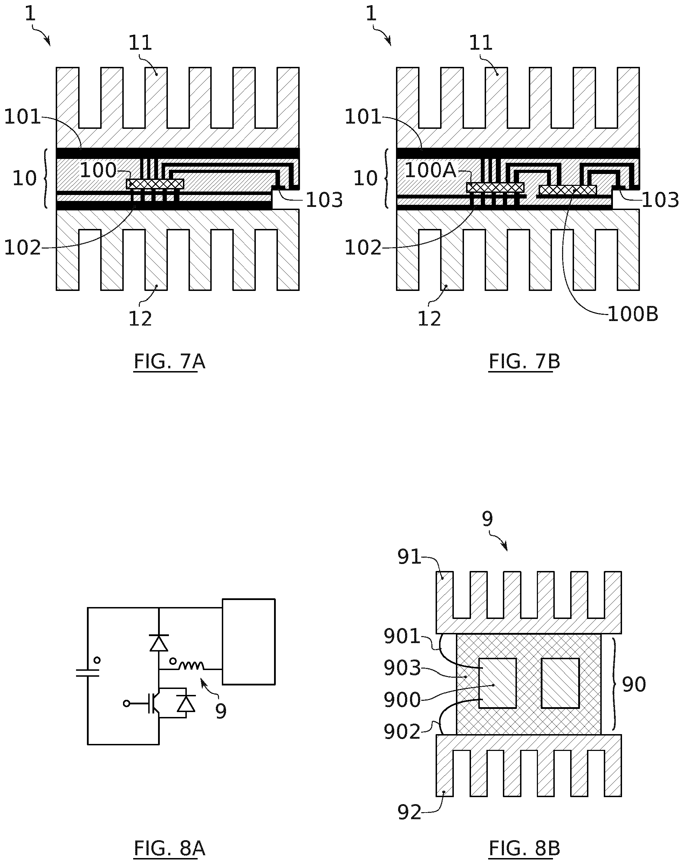

Comme illustré plus en détail aux figures 7A, 7B, le circuit imprimé 10, ou PCB (de l'acronyme anglais « Printed Circuit Board »), permet avantageusement de fournir des connectiques 101, 102, 103 pour différents composants électroniques semi-conducteurs 100, 100A, 100B, tels que des transistors 100, 100A, des diodes, des circuits de commande 100B etc. Il permet également d'agencer ces composants en optimisant la distribution du champ électrique autour de ces composants. L'intégration sur un même PCB 10 de différents composants 100A, 100B peut permettre un bon refroidissement de l'ensemble de ces composants.

L'utilisation d'un PCB 10 n'est cependant pas obligatoire. D'autres supports peuvent être envisagés.

Le circuit imprimé 10 présente de préférence une première face et une deuxième face opposée à la première face.

Le premier dissipateur thermique 11 est assemblé au niveau de la première face du circuit intégré 10, et le deuxième dissipateur thermique 12 est assemblé au niveau de la deuxième face du circuit intégré 10.

Les assemblages des premier et deuxième dissipateurs 11, 12 sur les première et deuxième faces du circuit intégré 10 peuvent être réalisés par brasure, soudure ou par frittage.

De tels assemblages permettent avantageusement de limiter les résistances thermiques de contact entre le ou les composants semi-conducteurs 100, 100A, 100B du PCB 10 et le ou les dissipateurs thermiques 11, 12.

De tels assemblages ne nécessitent pas de pression de serrage telle que requise pour un assemblage « press-pack ».

Ils permettent en outre de limiter le nombre d'interfaces thermiques entre le ou les composants semi-conducteurs du PCB 10 et le ou les dissipateurs thermiques 11, 12. L'efficacité de la dissipation de chaleur est dès lors améliorée.

La compacité du module 1 peut ainsi être optimisée.

Les premier et deuxième dissipateurs 11, 12 sont nécessairement conducteurs électriques.

Le premier dissipateur thermique 11 conducteur électrique, dit dissipateur anodique, est relié à une première électrode, dite anode, du composant de puissance 100.

Le deuxième dissipateur thermique 12 conducteur électrique, dit dissipateur cathodique, est relié à une deuxième électrode, dite cathode, du composant de puissance 100.

Les premier et deuxième dissipateurs 11, 12 peuvent être en aluminium afin de diminuer le poids total du module élémentaire 1.

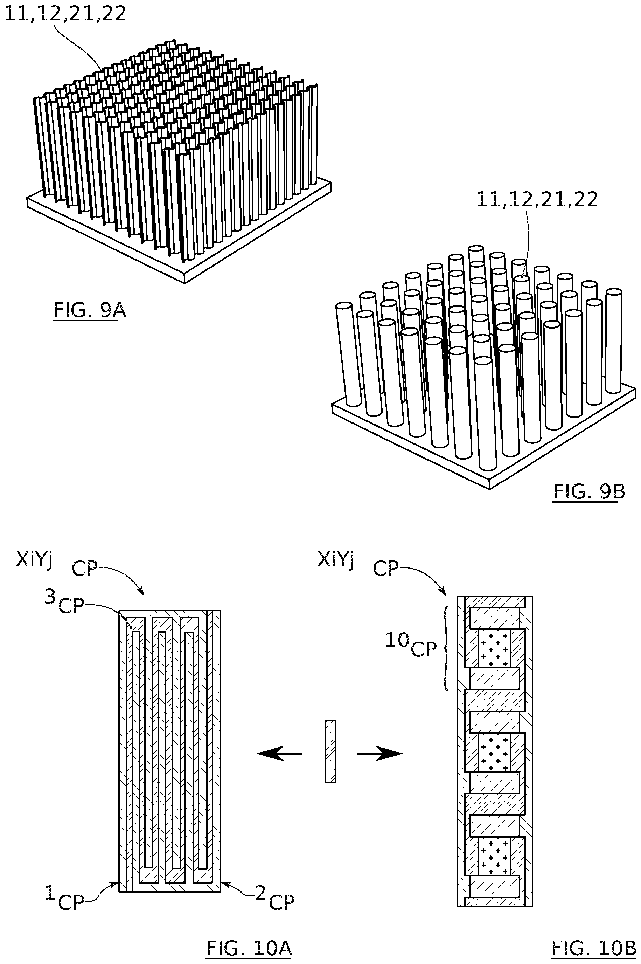

Ils peuvent comprendre des ailettes planes ou ondulées, telles qu'illustrées à la figure 9A, ou des broches ou des doigts tels qu'illustrés à la figure 9B, afin d'améliorer les transferts de chaleur et d'optimiser la dissipation thermique du ou des composants de puissance 100.

Dans le cas des doigts illustrés à la figure 9B, le fluide de refroidissement peut avantageusement circuler dans plusieurs directions. L'installation d'un dispositif de circulation fluidique est dès lors facilitée.

Le fluide de refroidissement peut être de l'air ou un liquide isolant.

Selon l'invention, les dissipateurs d'un module élémentaire permettent d'assurer au moins une connexion électrique avec les dissipateurs d'un module élémentaire adjacent du système électronique.

Chaque dissipateur présente de préférence une surface de connexion centrale et, pour un module élémentaire de section carrée ou rectangulaire dans le plan du circuit intégré, quatre surfaces de connexion latérales.

La connexion électrique au niveau de ces surfaces de connexion peut être conductrice, capacitive ou isolante.

On entend par connexion électrique isolante, une connexion électriquement isolante ou isolée électriquement.

La connexion électrique conductrice, capacitive ou isolante peut se faire respectivement par l'intermédiaire d'un élément conducteur, capacitif ou isolant. Elle peut se faire alternativement sans élément intermédiaire, directement à l'interface entre les surfaces de connexion.

Un élément conducteur XiYj_{C} par exemple massif ou sous forme de mousse peut améliorer le contact électrique entre les dissipateurs si nécessaire.

Un élément capacitif XiYj_{CP} tel qu'illustré aux figures 10A, 10B est de préférence utilisé pour la connexion électrique capacitive. Il peut avantageusement assurer une fonction de condensateur de découplage.

La surface d'un tel élément est de préférence supérieure ou égale à la surface de connexion correspondante du dissipateur, de sorte à obtenir une valeur de capacité relativement importante. La surface peut être comprise entre 1 cm² et 10 cm². La capacité peut être comprise entre 100 nF et 10 mF, de préférence entre 100 nF et 100 µF, de préférence entre 1 µF et 100 µF.

Selon un exemple illustré à la figure 10A, l'élément capacitif peut être formé par un condensateur plan comprenant un premier conducteur 1cp et un deuxième conducteur 2cp séparés par un matériau isolant 3cp. Cette solution est simple et peu coûteuse.

Selon un autre exemple illustré à la figure 10B, l'élément capacitif XiYj_{CP} peut se présenter sous la forme d'un PCB comprenant plusieurs condensateurs 10cp montés en parallèle. Cela permet avantageusement d'obtenir une capacité de forte valeur tout en limitant largement l'inductance équivalente série ESL (acronyme anglais de « Equivalent Series Inductance ») de cet élément capacitif. Les surtensions induites lors de commutations de composants rapides peuvent ainsi être avantageusement limitées.

La connexion électrique peut être centrale entre deux surfaces de connexion centrales de deux modules élémentaires adjacents.

Alternativement ou en combinaison, elle peut être latérale entre deux surfaces de connexion latérales de deux modules élémentaires adjacents.

Selon un exemple, deux modules élémentaires 1, 2 peuvent être assemblés en série par une connexion électrique centrale conductrice 1221c entre le dissipateur cathodique 12 du premier module élémentaire 1 et le dissipateur anodique 21 du deuxième module élémentaire 2, tel qu'illustré aux figures 2A, 2B.

Selon un autre exemple, deux modules élémentaires 1, 2 peuvent être assemblés en parallèle ou en anti-parallèle par des connexions électriques latérales conductrices 1121c, 1222c respectivement entre les dissipateurs anodiques 11, 21 des premier et deuxième modules élémentaires 1, 2, et entre les dissipateurs cathodiques 12, 22 des premier et deuxième modules élémentaires 1, 2, tel qu'illustré aux figures 3A, 3B.

Ces différentes configurations de connexions électriques entre modules adjacents permettent avantageusement de réaliser de nombreux systèmes électroniques.

L'assemblage des modules élémentaires entre eux peut être réalisé en maintenant un contact mécanique entre les différents dissipateurs participant aux connexions électriques. Cela permet notamment de monter/démonter facilement le système électronique pour sa maintenance ou pour son évolution par changement, ajout ou suppression de modules élémentaires comprenant certains composants.

L'assemblage peut être réalisé alternativement en collant ou en soudant les différents modules élémentaires entre eux.

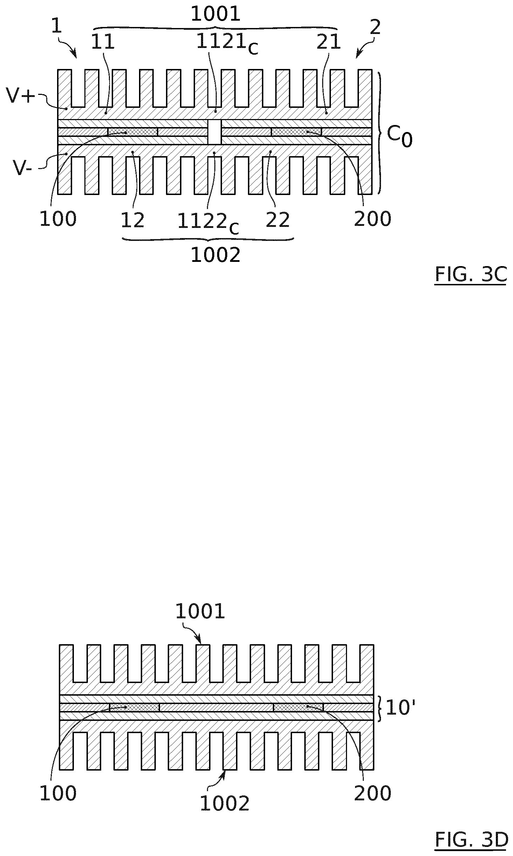

Selon un autre exemple illustré à la figure 3C, les dissipateurs anodiques 11, 21 des premier et deuxième modules élémentaires 1, 2 forment un seul et même dissipateur thermique anodique principal 1001. La connexion électrique latérale conductrice 1121c forme ici une partie du dissipateur thermique anodique principal 1001. Ce dissipateur thermique anodique principal 1001 est ainsi continu et/ou monobloc. Il est partagé entre les premier et deuxième modules élémentaires 1, 2. Dans cet exemple, les dissipateurs cathodiques 12, 22 des premier et deuxième modules élémentaires 1, 2 forment également un seul et même dissipateur thermique cathodique principal 1002. La connexion électrique latérale conductrice 1122c forme ici une partie du dissipateur thermique cathodique principal 1002. Ce dissipateur thermique cathodique principal 1002 est ainsi continu et/ou monobloc. Il est partagé entre les premier et deuxième modules élémentaires 1, 2.

Selon un exemple ne faisant pas partie de la présente invention illustré à la figure 3D, les circuits imprimés 10, 20 des premier et deuxième modules élémentaires 1, 2 forment un seul et même circuit imprimé 10'. Le circuit imprimé 10' comprend dès lors les premier et deuxième composants de puissance 100, 200. Un tel circuit imprimé 10' est de préférence associé à des dissipateurs 1001, 1002 s'étendant sur les faces dudit circuit imprimé 10'.

Selon une possibilité non illustrée, une pluralité de modules élémentaires assemblés en parallèle, par exemple trois, quatre ou plus, peuvent partager un seul et même dissipateur thermique anodique principal et/ou un seul et même dissipateur thermique cathodique principal, selon un exemple ne faisant pas partie de la présente invention. De même, un seul et même circuit imprimé peut comprendre les composants de puissance d'une pluralité de modules élémentaires assemblés entre eux.

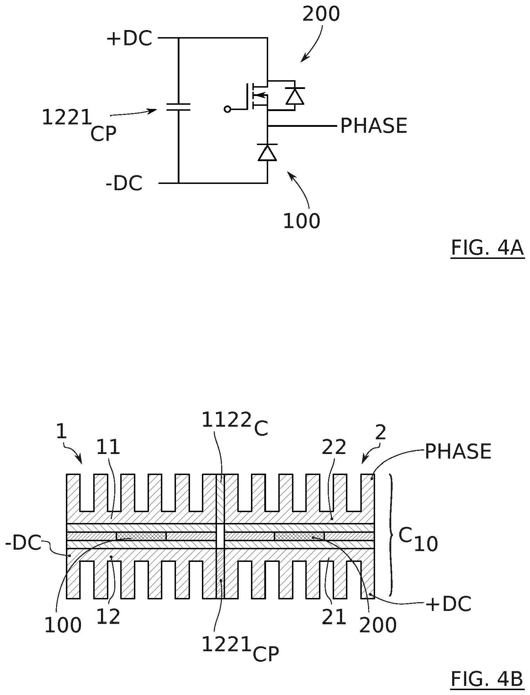

Selon un premier mode de réalisation de l'invention illustré aux figures 4A, 4B, le système électronique est une cellule de commutation.

Selon ce mode de réalisation, deux modules élémentaires 1, 2 sont de préférence assemblés par :
- une connexion électrique latérale conductrice 1122c entre le dissipateur anodique 11 du premier module élémentaire 1 et le dissipateur cathodique 22 du deuxième module élémentaire 2, et
- une connexion électrique latérale capacitive 1221cp entre le dissipateur cathodique 12 du premier module élémentaire 1 et le dissipateur anodique 21 du deuxième module élémentaire 2. La connexion électrique latérale capacitive 1221cp permet d'intégrer une capacité de découplage au sein de la cellule de commutation de façon à diminuer avantageusement les inductances parasites.

Le composant de puissance 100 du premier module 1 peut être une diode et l'au moins un composant de puissance 200 du deuxième module 2 peut être un transistor associé à une diode en anti-parallèle par exemple, tel qu'illustré sur le schéma électronique à la figure 4A.

L'association en anti-parallèle d'une diode et d'un transistor peut se faire directement au sein d'un même module élémentaire, par exemple de façon intégré sur le PCB, ou par l'intermédiaire de deux modules élémentaires distincts, l'un comprenant le transistor et l'autre la diode, connectés en anti-parallèle.

Selon une possibilité, les composants de puissance 100, 200 des premier et deuxième modules 1, 2 peuvent être des transistors, par exemple IGBT, éventuellement chacun associé à une diode en anti-parallèle.

Les potentiels +DC et -DC associés à la source de tension et le potentiel *phase* associé à la sortie à point milieu permettant d'alimenter la charge sont représentés sur le schéma électronique (figure 4A) et sur le schéma physique (figure 4B) par souci de clarté.

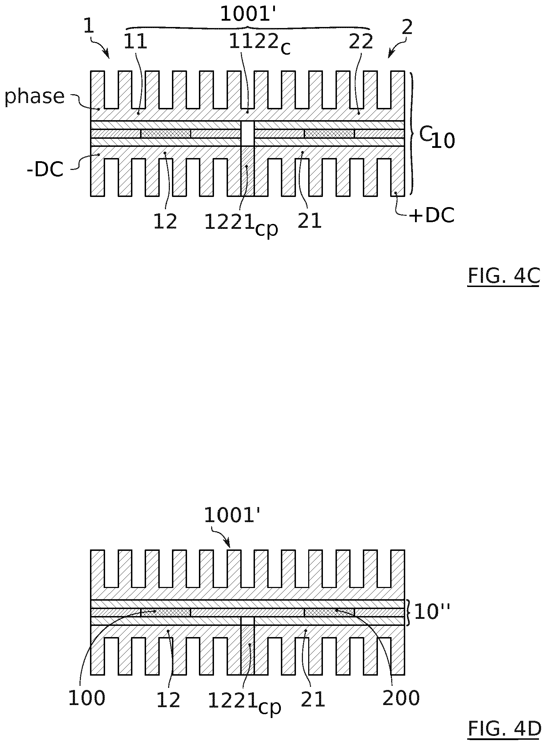

Selon un exemple illustré à la figure 4C, le dissipateur anodique 11 et le dissipateur cathodique 22 forment un seul et même dissipateur thermique 1001'. La connexion électrique latérale conductrice 1122c forme ici une partie du dissipateur thermique 1001'. Ce dissipateur thermique 1001' est ainsi continu et/ou monobloc. Il est partagé entre les premier et deuxième modules élémentaires 1, 2.

Selon un exemple illustré à la figure 4D, les circuits imprimés 10, 20 des premier et deuxième modules élémentaires 1, 2 forment un seul et même circuit imprimé 10". Le circuit imprimé 10" comprend dès lors les premier et deuxième composants de puissance 100, 200. Un tel circuit imprimé 10" est de préférence associé au dissipateur 1001' s'étendant sur une première face dudit circuit imprimé 10". Une deuxième face du circuit imprimé 10", opposée à la première face, supporte les dissipateurs cathodique 12 et anodique 21. Cette deuxième face est de préférence discontinue au niveau de la connexion électrique latérale capacitive 1221cp, de sorte à ne pas court-circuiter les dissipateurs cathodique 12 et anodique 21.

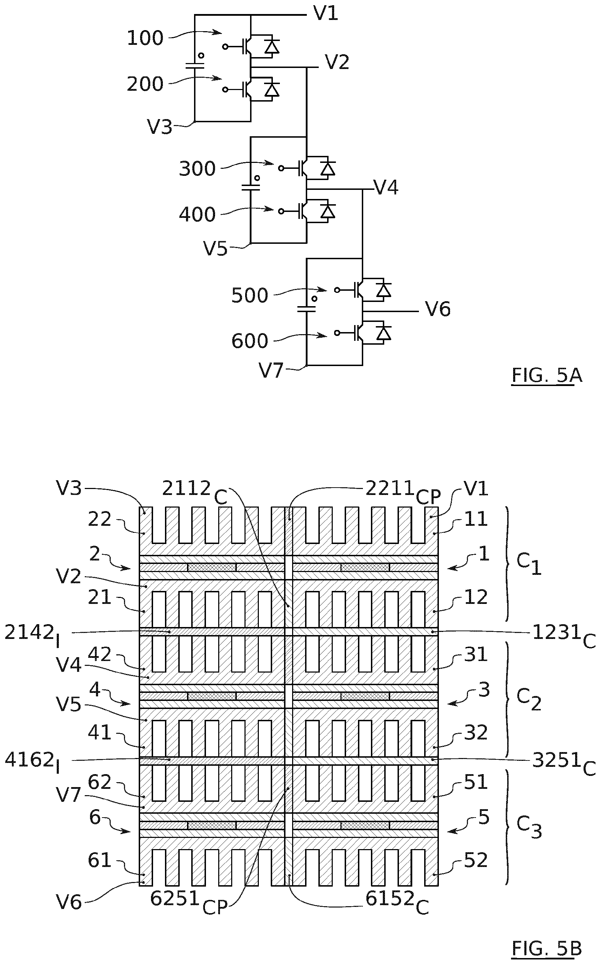

Selon un deuxième mode de réalisation de l'invention illustré aux figures 5A, 5B, le système électronique est un demi-bras de convertisseur modulaire multiniveaux MMC (acronyme anglais de « Multilevel Modular Converter»).

Selon ce mode de réalisation, trois cellules de commutation C1, C2, C3 telles que décrites dans le premier mode de réalisation sont connectées en série.

De préférence, chaque module élémentaire 1, 2, 3, 4, 5, 6 comprend un transistor IGBT associé à une diode en anti-parallèle, formant respectivement les composants de puissance 100, 200, 300, 400, 500, 600 tel qu'illustré sur le schéma électronique à la figure 5A.

Structurellement, la première cellule de commutation C1 comprenant deux modules élémentaires 1, 2 est connectée à la deuxième cellule de commutation C2 comprenant deux modules élémentaires 3, 4, de préférence par une connexion électrique centrale conductrice 1231c entre le dissipateur cathodique 12 du module 1 et le dissipateur anodique 31 du module 3, et par une connexion électrique centrale isolante 2142i entre le dissipateur anodique 21 du module 2 et le dissipateur cathodique 42 du module 4.

La deuxième cellule de commutation C2 comprenant deux modules élémentaires 3, 4 est connectée à la troisième cellule de commutation C3 comprenant deux modules élémentaires 5, 6, de préférence par une connexion électrique centrale conductrice 3251c entre le dissipateur cathodique 32 du module 3 et le dissipateur anodique 51 du module 5, et par une connexion électrique centrale isolante 4162i entre le dissipateur anodique 41 du module 4 et le dissipateur cathodique 62 du module 6.

Les potentiels V1, V2, V3, V4, V5, V6, V7 associés aux différents étages du MMC sont représentés sur le schéma électronique (figure 5A) et sur le schéma physique (figure 5B) par souci de clarté.

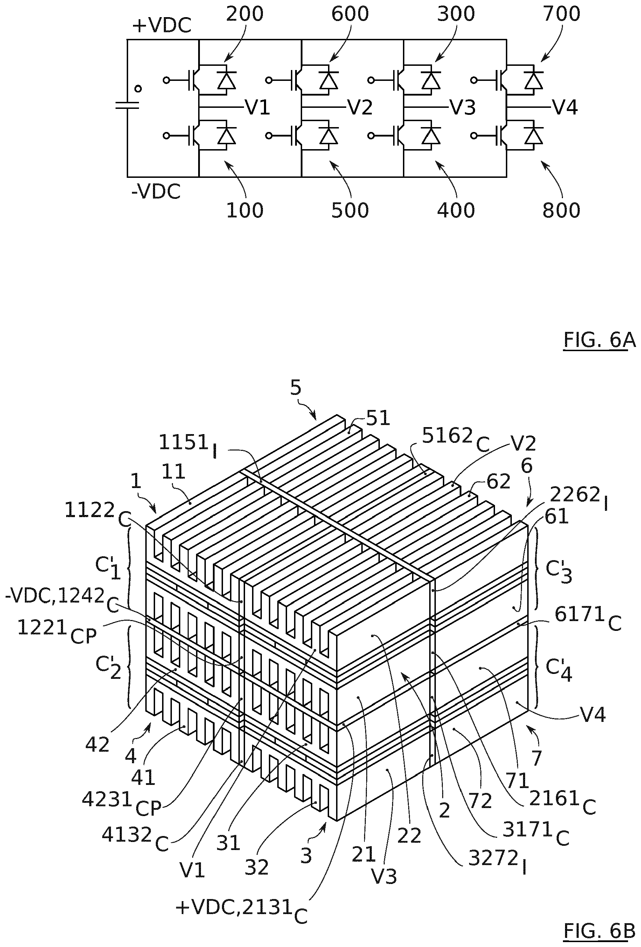

Selon un troisième mode de réalisation de l'invention illustré aux figures 6A, 6B, le système électronique est un hacheur entrelacé à quatre bras de pont.

Selon ce mode de réalisation, quatre cellules de commutation C1', C2', C3', C4' telles que décrites dans le premier mode de réalisation sont connectées en parallèle.

De préférence, chaque module élémentaire 1, 2, 3, 4, 5, 6, 7, 8 comprend un transistor IGBT associé à une diode en anti-parallèle, formant respectivement les composants de puissance 100, 200, 300, 400, 500, 600, 700, 800 tel qu'illustré sur le schéma électronique à la figure 6A.

Une telle structure peut être réalisée en combinant des connexions électriques centrales et des connexions électriques latérales entre cellules de commutation C1', C2', C3', C4'.

La première cellule de commutation C1' comprenant deux modules élémentaires 1, 2 est connectée à la deuxième cellule de commutation C2' comprenant deux modules élémentaires 3, 4, de préférence par une connexion électrique centrale conductrice 2131c entre le dissipateur anodique 21 du module 2 et le dissipateur anodique 31 du module 3, et par une connexion électrique centrale conductrice 1242c entre le dissipateur cathodique 12 du module 1 et le dissipateur cathodique 42 du module 4.

La troisième cellule de commutation C3' comprenant deux modules élémentaires 5, 6 est connectée à la quatrième cellule de commutation C4' comprenant deux modules élémentaires 7, 8, de préférence par une connexion électrique centrale conductrice 5282c entre le dissipateur cathodique 52 du module 5 et le dissipateur cathodique 82 du module 8, et par une connexion électrique centrale conductrice 6171c entre le dissipateur anodique 61 du module 6 et le dissipateur anodique 71 du module 7.

La première cellule de commutation C1' comprenant deux modules élémentaires 1, 2 est connectée à la troisième cellule de commutation C3' comprenant deux modules élémentaires 5, 6, de préférence par :
- des connexions électriques latérales conductrices 1252c, 2161c, respectivement entre le dissipateur cathodique 12 du module 1 et le dissipateur cathodique 52 du module 5, et entre le dissipateur anodique 21 du module 2 et le dissipateur anodique 61 du module 6, et par,
- des connexions électriques latérales isolantes 1151i, 2262i, respectivement entre le dissipateur anodique 11 du module 1 et le dissipateur anodique 51 du module 5, et entre le dissipateur cathodique 22 du module 2 et le dissipateur cathodique 62 du module 6.

La deuxième cellule de commutation C2' comprenant deux modules élémentaires 3, 4 est connectée à la quatrième cellule de commutation C4' comprenant deux modules élémentaires 7, 8, de préférence par :
- des connexions électriques latérales conductrices 3171c, 4282c, respectivement entre le dissipateur anodique 31 du module 3 et le dissipateur anodique 71 du module 7, et entre le dissipateur cathodique 42 du module 4 et le dissipateur cathodique 82 du module 8, et par,
- des connexions électriques latérales isolantes 3272i, 4181i, respectivement entre le dissipateur cathodique 32 du module 3 et le dissipateur cathodique 72 du module 7, et entre le dissipateur anodique 41 du module 4 et le dissipateur anodique 81 du module 8.

Les potentiels V1, V2, V3, V4, associés aux différentes sorties à point milieu des bras du hacheur sont représentés sur le schéma électronique (figure 6A) et sur le schéma physique (figure 6B) par souci de clarté.

Cette structure peut comprendre plus que quatre cellules de commutation, par exemple six, ou moins, par exemple trois, pour former un hacheur entrelacé comprenant le nombre de bras souhaité.

Pour un nombre impair de cellules de commutation, par exemple trois, celles-ci peuvent toutes être connectées latéralement entre elles sur le principe des connexions latérales entre C1' et C3' exposé plus haut. Alternativement, des connexions centrales entre toutes les cellules sont également envisageables. Selon une autre possibilité, une cellule partage une connexion latérale ou centrale avec deux cellules adjacentes, par exemple par un positionnement décalé de ladite cellule vis-à-vis des deux autres, ou par un ou des éléments de connexion se prolongeant sur les surfaces de connexion des deux cellules adjacentes considérées.

Selon un mode de réalisation, le système électronique peut comprendre au moins un module d'inductance élémentaire 9 tel qu'illustré à la figure 8B.

Ce module d'inductance élémentaire 9 peut être réalisé de façon similaire à un module de puissance élémentaire 1, afin d'être intégré facilement au système électronique.

En particulier, un tel module d'inductance élémentaire 9 peut comprendre une bobine conductrice 900 noyée dans une matrice magnétique 903.

Un premier dissipateur thermique 91 conducteur électrique est de préférence situé sur une première face de la matrice magnétique 903.

Un deuxième dissipateur thermique 92 conducteur électrique est de préférence situé sur une deuxième face de la matrice magnétique 903 opposée à la première face.

Les premier et deuxième dissipateurs thermiques 91, 92 sont de préférence reliés à la bobine conductrice 900, par exemple par des connexions filaires 901, 902.

Comme illustré à la figure 8A, un tel module d'inductance élémentaire 9 peut être avantageusement connecté à la sortie à point milieu d'une cellule de commutation telle que décrite dans le premier mode de réalisation de l'invention.

L'association de modules d'inductance 9 en série permet par exemple d'augmenter l'inductance totale du système électronique.

L'association de modules d'inductance 9 en parallèle permet par exemple d'augmenter l'intensité maximale de courant électrique admissible par le système électronique.

Le système électronique selon l'invention peut ainsi comprendre une pluralité de modules de puissance élémentaires et/ou une pluralité de modules d'inductance élémentaires connectés entre eux par l'intermédiaire de leurs dissipateurs thermiques respectifs.

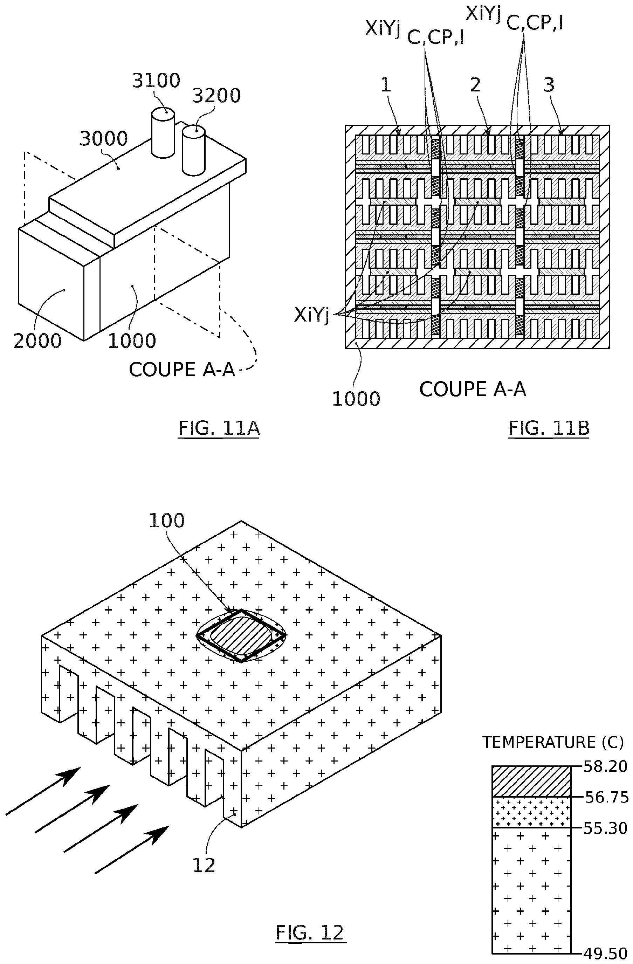

Ce système électronique est de préférence intégré dans un boîtier 1000 et couplé à un dispositif de refroidissement 2000 comme illustré aux figures 11A, 11B.

Une barre omnibus 3000 comprenant des connexions d'entrée/sortie (non représentées), encore appelée jeu de barres ou « busbar » selon la terminologie anglo-saxonne, est de préférence utilisée pour le raccordement des différents modules 1, 2, 3 du système électronique. Des condensateurs de filtrage 3100, 3200 peuvent compléter le système électronique.

Le système de refroidissement 2000, par exemple un ventilateur, est de préférence dimensionné pour refroidir l'ensemble des modules du système électronique.

La gestion thermique d'un tel système est ainsi facilitée.

La circulation du fluide de refroidissement et, subséquemment, l'efficacité du refroidissement sont optimisées.

La compacité du système peut ainsi être améliorée.

La masse globale du système est également diminuée.

La figure 12 présente une simulation thermique au sein d'un composant 100 d'un module de puissance élémentaire du système électronique selon l'invention. Le dissipateur thermique 12 est visible sur cette figure 12. L'ensemble est refroidi sous un flux d'air présentant une vitesse de 3,6 m/s.

L'objectif de cette simulation est de dimensionner le module et/ou le système de façon à obtenir des performances de refroidissement au moins équivalentes à celles d'un système classique.

Un système classique commercialisé par Semikron comprend un dissipateur de type P3/150 associé à douze composants et à un ventilateur SKF 3-230-01. L'ensemble a une masse de 3,1 kg, dont 0,55 kg pour le ventilateur. Pour un flux d'air présentant une vitesse de 3,6 m/s généré par le ventilateur, la résistance thermique par composant est de 1,7 K/W. La perte de charge est de l'ordre de 20 Pa.

Le système électronique selon l'invention dimensionné pour obtenir ces performances comprend un ventilateur et douze modules élémentaires comprenant chacun un composant et deux dissipateurs en aluminium à ailettes droites.

Chaque dissipateur présente une base carrée d'épaisseur 2 mm et de dimensions 30 mm X 30 mm. Chaque dissipateur comprend douze ailettes de 1,4 mm de largeur et de 15 mm de hauteur.

La résistance thermique par composant obtenue dans ces conditions est de l'ordre de 1 K/W. La perte de charge est de l'ordre de 24 Pa.

La masse globale associée à ce système est de 1,2 kg (24 dissipateurs de 26,2 g et 0,55 kg pour le ventilateur).

Ce système électronique est donc environ trois fois plus léger que le système classique et présente selon cette simulation de meilleures performances thermiques que le système classique.

Un tel système électronique refroidi par air et présentant une masse optimisée peut être avantageusement utilisé dans le domaine des transports, en particulier en aéronautique.

L'invention n'est pas limitée aux modes de réalisations précédemment décrits et s'étend à tous les modes de réalisation couverts par les revendications.

## Revendications

1. Système électronique comprenant au moins une cellule électronique (C0), ladite au moins une cellule électronique (C0) comprenant :
- Un premier module électronique de puissance élémentaire (1), dit premier module élémentaire (1),
- Un deuxième module électronique de puissance élémentaire (2), dit deuxième module élémentaire (2),
Lesdits premier et deuxième modules élémentaires (1, 2) étant adjacents et connectés entre eux par une connexion électrique de modules,
chacun de ces premier et deuxième modules élémentaires (1, 2) comprenant :
- au moins un composant de puissance (100, 200), de préférence intégré sur ou dans un circuit imprimé (10),
- un premier dissipateur thermique conducteur électrique (11, 21), dit dissipateur anodique, relié à une première électrode dite anode du composant de puissance (100, 200), et
- un deuxième dissipateur thermique conducteur électrique (12, 22), dit dissipateur cathodique, relié à une deuxième électrode dite cathode du composant de puissance (100, 200),
dans ledit système électronique, chaque dissipateur cathodique (12, 22) présente une première surface de connexion (120) dite surface centrale cathodique et au moins une deuxième surface de connexion (121, 122, 222) dite surface latérale cathodique, et
chaque dissipateur anodique (11, 21) présente une première surface de connexion (110, 210) dite surface centrale anodique et au moins une deuxième surface de connexion (111, 112, 212) dite surface latérale anodique, et la connexion électrique de modules entre les premier et deuxième modules élémentaires (1, 2) adjacents comprend au moins une connexion électrique latérale conductrice (1121c, 1222c) entre :
au moins une parmi les surfaces latérales anodique et cathodique (111, 121) du premier module élémentaire (1), et
au moins une parmi les surfaces latérales anodique et cathodique (212, 222) du deuxième module élémentaire (2).

2. Système selon la revendication précédente dans lequel la connexion électrique de modules entre les premier et deuxième modules élémentaires (1, 2) adjacents comprend en outre l'une parmi une connexion électrique latérale capacitive (1222cp) et une connexion électrique latérale isolante (1221i) entre :
au moins une autre parmi les surfaces latérales anodique et cathodique (111, 121) du premier module élémentaire (1), et
au moins une autre parmi les surfaces latérales anodique et cathodique (212, 222) du deuxième module élémentaire (2).

3. Système selon la revendication précédente dans lequel au moins une surface latérale anodique (111) du premier module élémentaire (1) est connectée à au moins une surface latérale cathodique (222) du deuxième module élémentaire (2) par une connexion électrique latérale conductrice (1122c) et au moins une surface latérale cathodique (121) du premier module élémentaire (1) est connectée à au moins une surface latérale anodique (212) du deuxième module élémentaire (2) par une connexion électrique choisie parmi une connexion électrique latérale capacitive (1221cp) et une connexion électrique latérale isolante (1221i).

4. Système selon la revendication précédente dans lequel l'au moins un composant de puissance (100) du premier module élémentaire (1) est l'un parmi un premier transistor de puissance et une première diode de puissance, et l'au moins un composant de puissance (200) du deuxième module élémentaire (2) est l'un parmi un deuxième transistor de puissance et une deuxième diode de puissance, de sorte que la cellule électronique forme une cellule de commutation (C10).

5. Système selon l'une quelconque des revendications précédentes comprenant une pluralité de cellules électroniques adjacentes et connectées entre elles, une cellule électronique (C1, C1') de la pluralité de cellules électroniques étant connectée à au moins une cellule électronique adjacente (C2, C2') par une connexion électrique de cellules, ladite connexion électrique de cellules comprenant au moins l'une parmi une connexion électrique centrale conductrice (1231c, 1242c), une connexion électrique centrale capacitive et une connexion électrique centrale isolante (2142i) entre :
au moins une parmi les surfaces centrales anodique et cathodique de la cellule (C1, C1'), et
au moins une parmi les surfaces centrales anodique et cathodique de l'au moins une cellule adjacente (C2, C2') à ladite cellule (C1, C1').

6. Système selon la revendication précédente dans lequel au moins une surface centrale cathodique (120) de la cellule (C1) est connectée à au moins une surface centrale anodique (310) de la cellule adjacente (C2) par une connexion électrique centrale conductrice (1231c) et au moins une surface centrale anodique (210) de la cellule (C1) est connectée à au moins une surface centrale cathodique (420) de la cellule adjacente (C2) par une connexion électrique centrale isolante (2142i).

7. Système selon la revendication précédente et la revendication 4 dans lequel chaque cellule électronique (C1, C2, C3) de la pluralité de cellules électroniques est une cellule de commutation (C10), de sorte que le système forme un sous-ensemble d'un convertisseur de puissance multiniveaux.

8. Système selon la revendication 5 dans lequel la connexion électrique de cellules comprend en outre au moins une connexion électrique latérale conductrice (1252c, 2161c) entre :
au moins une parmi les surfaces latérales anodique et cathodique de la cellule (C1'), et
au moins une parmi les surfaces latérales anodique et cathodique d'au moins une autre cellule adjacente (C3') à ladite cellule (C1').

9. Système selon la revendication précédente et la revendication 4 comprenant une première cellule électronique (C1'), une deuxième cellule électronique (C2'), une troisième cellule électronique (C3'), une quatrième cellule électronique (C4'), lesdites première, deuxième, troisième, quatrième cellules électroniques (C1', C2', C3', C4') étant des cellules de commutation (C10), dans lequel :
Les surfaces centrales anodique et cathodique des dissipateurs thermiques anodique (21) et cathodique (12) reliés entre eux par une connexion électrique latérale capacitive (1221cp) de la première cellule (C1') sont respectivement connectées aux surfaces centrales anodique et cathodique des dissipateurs thermiques anodique (31) et cathodique (42) reliés entre eux par une connexion électrique latérale capacitive (4231cp) de la deuxième cellule (C2'), par des connexions électriques centrales conductrices (2131c, 1242c),
Les surfaces centrales anodique et cathodique des dissipateurs thermiques anodique (61) et cathodique (52) reliés entre eux par une connexion électrique latérale capacitive (5261cp) de la troisième cellule (C3') sont respectivement connectées aux surfaces centrales anodique et cathodique des dissipateurs thermiques anodique (71) et cathodique (82) reliés entre eux par une connexion électrique latérale capacitive (8271cp) de la quatrième cellule (C4'), par des connexions électriques centrales conductrices (6171c, 5282c),
Les surfaces latérales anodique et cathodique des dissipateurs thermiques anodique (11) et cathodique (22) reliés entre eux par une connexion électrique latérale conductrice (1122c), situées sur un même côté de la première cellule (C1') sont respectivement connectées aux surfaces latérales anodique et cathodique des dissipateurs thermiques anodique (51) et cathodique (62) reliés entre eux par une connexion électrique latérale conductrice (5162c), situées sur un même côté de la troisième cellule (C3'), par des connexions électriques latérales isolantes (1151i, 2262i),
Les surfaces latérales anodique et cathodique des dissipateurs thermiques anodique (21) et cathodique (12) reliés entre eux par une connexion électrique latérale capacitive (1221cp), situées sur un même côté de la première cellule (C1') sont respectivement connectées aux surfaces latérales anodique et cathodique des dissipateurs thermiques anodique (61) et cathodique (52) reliés entre eux par une connexion électrique latérale capacitive (5261cp), situées sur un même côté de la troisième cellule (C3'), par des connexions électriques latérales conductrices (2161c, 1252c),
Les surfaces latérales anodique et cathodique des dissipateurs thermiques anodique (31) et cathodique (42) reliés entre eux par une connexion électrique latérale capacitive (4231cp), situées sur un même côté de la deuxième cellule (C2') sont respectivement connectées aux surfaces latérales anodique et cathodique des dissipateurs thermiques anodique (71) et cathodique (82) reliés entre eux par une connexion électrique latérale capacitive (8271cp), situées sur un même côté de la quatrième cellule (C4'), par des connexions électriques latérales conductrices (3171c, 4282c),
Les surfaces latérales anodique et cathodique des dissipateurs thermiques anodique (41) et cathodique (32) reliés entre eux par une connexion électrique latérale conductrice (4132c), situées sur un même côté de la deuxième cellule (C2') sont respectivement connectées aux surfaces latérales anodique et cathodique des dissipateurs thermiques anodique (81) et cathodique (72) reliés entre eux par une connexion électrique latérale conductrice (8172c), situées sur un même côté de la quatrième cellule (C4'), par des connexions électriques latérales isolantes (4181i, 3272i),
de sorte que le système forme un convertisseur de puissance de type hacheur entrelacé.

10. Système selon l'une quelconque des revendications précédentes dans lequel chaque dissipateur (11, 12, 21, 22) comprend au moins l'un parmi une ailette et un doigt.

11. Système selon l'une quelconque des revendications précédentes à l'exception des revendications 1, 5 et 9 dans lequel l'une au moins parmi la connexion électrique latérale capacitive (1221cp, 2211cp, 6251cp, 4231cp) et la connexion électrique centrale capacitive comprend au moins un condensateur (10cp).

12. Système selon l'une quelconque des revendications précédentes comprenant en outre un dispositif de refroidissement (2000) configuré pour refroidir chaque dissipateur thermique anodique et cathodique (11, 12, 21, 22).

13. Système selon l'une quelconque des revendications précédentes comprenant en outre au moins un module d'inductance élémentaire (9) comprenant :
- Une bobine conductrice (900) noyée dans une matrice magnétique (903) présentant une première face et une deuxième face opposée à la première face,
- un premier dissipateur thermique (91) conducteur électrique sur la première face et relié à ladite bobine conductrice (900), et
- un deuxième dissipateur thermique (92) conducteur électrique sur la deuxième face et relié à ladite bobine conductrice (900).

## Patentansprüche

1. Elektronisches System, das mindestens eine elektronische Zelle (C0) umfasst, wobei die mindestens eine elektronische Zelle (C0) Folgendes umfasst:
- ein erstes elektronisches Elementarleistungsmodul (1), das sogenannte erste Elementarmodul (1),
- ein zweites elektronisches Elementarleistungsmodul (2), das sogenannte zweite Elementarmodul (2),
wobei das erste und das zweite Elementarmodul (1, 2) nebeneinander liegen und durch eine elektrische Modulverbindung miteinander verbunden sind,
wobei jedes diesen ersten und diesen zweiten Elementarmoduls (1, 2) Folgendes umfasst:
- mindestens eine Leistungskomponente (100, 200), die vorzugsweise auf oder in eine Leiterplatte (10) integriert ist,
- einen ersten elektrisch leitfähigen Kühlkörper (11, 21), den sogenannten Anodenkühlkörper, der mit einer ersten Elektrode, der sogenannten Anode, der Leistungskomponente (100, 200) verbunden ist, und
- einen zweiten elektrisch leitfähigen Kühlkörper (12, 22), den sogenannten Kathodenkühlkörper, der mit einer zweiten Elektrode, der sogenannten Kathode, der Leistungskomponente (100, 200) verbunden ist,
wobei in dem elektronischen System
jeder Kathodenkühlkörper (12, 22) eine erste Verbindungsfläche (120), die sogenannte zentrale Kathodenfläche, und mindestens eine zweite Verbindungsfläche (121, 122, 222), die sogenannte seitliche Kathodenfläche, aufweist und
jeder Anodenkühlkörper (11, 21) eine erste Verbindungsfläche (110, 210), die sogenannte zentrale Anodenfläche, und mindestens eine zweite Verbindungsfläche (111, 112, 212), die sogenannte seitliche Anodenfläche, aufweist und
die elektrische Verbindung von Modulen zwischen dem benachbarten ersten und zweiten Elementarmodul (1, 2) mindestens eine leitfähige seitliche elektrische Verbindung (1121c, 1222c) zwischen:
Mindestens einer der seitlichen Anoden- und Kathodenflächen (111, 121) des ersten Elementarmoduls (1) und
mindestens einer der seitlichen Anoden- und Kathodenflächen (212, 222) des zweiten Elementarmoduls (2)
umfasst.

2. System nach dem vorhergehenden Anspruch, wobei die elektrische Verbindung von Modulen zwischen dem benachbarten ersten und zweiten Elementarmodule (1, 2) ferner eine kapazitive seitliche elektrische Verbindung (1222cp) und eine isolierende seitliche elektrische Verbindung (1221i) zwischen:
Mindestens einer weiteren der seitlichen Anoden- und Kathodenflächen (111, 121) des ersten Elementarmoduls (1) und
mindestens einer weiteren der seitlichen Anoden- und Kathodenflächen (212, 222) des zweiten Elementarmoduls (2)
umfasst.

3. System nach dem vorhergehenden Anspruch, wobei mindestens eine seitliche Anodenfläche (111) des ersten Elementarmoduls (1) mit mindestens einer seitlichen Kathodenfläche (222) des zweiten Elementarmoduls (2) durch eine leitfähige seitliche elektrische Verbindung (1122c) verbunden ist und mindestens eine seitliche Kathodenfläche (121) des ersten Elementarmoduls (1) mit mindestens einer seitlichen Anodenfläche (212) des zweiten Elementarmoduls (2) durch eine elektrische Verbindung, ausgewählt aus einer kapazitiven seitlichen elektrischen Verbindung (1221cp) und einer isolierenden seitlichen elektrischen Verbindung (1221i), verbunden ist.

4. System nach dem vorhergehenden Anspruch, wobei die mindestens eine Leistungskomponente (100) des ersten Elementarmoduls (1) eines ist von einem ersten Leistungstransistor oder einer ersten Leistungsdiode und die mindestens eine Leistungskomponente (200) des zweiten Elementarmoduls (2) eines ist von einem zweiten Leistungstransistor und einem zweiten Leistungsdiode, so dass die elektronische Zelle eine Schaltzelle (C10) bildet.

5. System nach einem der vorhergehenden Ansprüche, umfassend mehrere benachbarte elektronische Zellen, die miteinander verbunden sind, wobei eine elektronische Zelle (C1, C1`) der mehreren elektronischen Zellen mit mindestens einer benachbarten elektronischen Zelle (C2, C2`) durch eine elektrische Zellverbindung verbunden ist, wobei die elektrische Zellverbindung mindestens eine von einer leitfähigen zentralen elektrischen Verbindung (1231c, 1242c), einer kapazitiven zentralen elektrischen Verbindung und einer isolierenden zentralen elektrischen Verbindung (2142i) zwischen:
Mindestens einer von den zentralen Anoden- und Kathodenflächen der Zelle (C1, C1') und
mindestens einer von den zentralen Anoden- und Kathodenflächen der mindestens einen benachbarten Zelle (C2, C2`) zu der Zelle (C1, C1')
umfasst.

6. System nach dem vorhergehenden Anspruch, wobei mindestens eine zentrale Kathodenfläche (120) der Zelle (C1) mit mindestens einer zentralen Anodenfläche (310) der benachbarten Zelle (C2) durch eine leitfähige zentrale elektrische Verbindung (1231c) verbunden ist und mindestens eine zentrale Anodenfläche (210) der Zelle (C1) mit mindestens einer zentralen Kathodenfläche (420) der benachbarten Zelle (C2) durch eine isolierende zentrale elektrische Verbindung (2142i) verbunden ist.

7. System nach dem vorhergehenden Anspruch und Anspruch 4, wobei jede elektronische Zelle (C1, C2, C3) der mehreren elektronischen Zellen eine Schaltzelle (C10) ist, so dass das System eine Teilmenge eines mehrstufigen Leistungswandlers bildet.

8. System nach Anspruch 5, wobei die elektrische Zellverbindung ferner mindestens eine leitfähige seitliche elektrische Verbindung (1252c, 2161c) zwischen:
Mindestens einer von den seitlichen Anoden- und Kathodenflächen der Zelle (C1') und
mindestens einer von den seitlichen Anoden- und Kathodenflächen von mindestens einer anderen benachbarten Zelle (C3`) zu der Zelle (C1')
umfasst.

9. System nach dem vorhergehenden Anspruch und Anspruch 4, umfassend eine erste elektronische Zelle (C1'), eine zweite elektronische Zelle (C2'), eine dritte elektronische Zelle (C3'), eine vierte elektronische Zelle (C4'), wobei die erste, die zweite, die dritte und die vierte elektronische Zelle (C1', C2', C3', C4`) Schaltzellen (C10) sind, wobei:
Die zentralen Anoden- und Kathodenflächen des Anodenkühlkörpers (21) und des Kathodenkühlkörpers (12), die durch eine kapazitive seitliche elektrische Verbindung (1221cp) der ersten Zelle (C1') miteinander verbunden sind, jeweils mit den zentralen Anoden- und Kathodenflächen des Anodenkühlkörpers (31) und des Kathodenkühlkörpers (42), die durch eine kapazitive seitliche elektrische Verbindung (4231cp) der zweiten Zelle (C2') miteinander verbunden sind, durch leitfähige zentrale elektrische Verbindungen (2131c, 1242c) verbunden sind,
die zentralen Anoden- und Kathodenflächen des Anodenkühlkörpers (61) und des Kathodenkühlkörpers (52), die durch eine kapazitive seitliche elektrische Verbindung (5261cp) der dritten Zelle (C3') miteinander verbunden sind, jeweils mit den zentralen Anoden- und Kathodenflächen des Anodenkühlkörpers (71) und des Kathodenkühlkörpers (82), die durch eine kapazitive seitliche elektrische Verbindung (8271cp) der vierten Zelle (C4`) miteinander verbunden sind, durch leitfähige zentrale elektrische Verbindungen (6171c, 5282c) verbunden sind,
die seitlichen Anoden- und Kathodenflächen des Anodenkühlkörpers (11) und des Kathodenkühlkörpers (22), die durch eine leitfähige seitliche elektrische Verbindung (1122c) miteinander verbunden sind und sich auf derselben Seite der ersten Zelle (C1') befinden, jeweils mit den seitlichen Anoden- und Kathodenflächen des Anodenkühlkörpers (51) und des Kathodenkühlkörpers (62), die durch eine leitfähige seitliche elektrische Verbindung (5162c) miteinander verbunden sind und sich auf derselben Seite der dritten Zelle (C3`) befinden, durch isolierende seitliche elektrische Verbindungen (1151i, 2262i) verbunden sind,
die seitlichen Anoden- und Kathodenflächen des Anodenkühlkörpers (21) und des Kathodenkühlkörpers (12), die durch eine kapazitive seitliche elektrische Verbindung (1221cp) miteinander verbunden sind und sich auf derselben Seite der ersten Zelle (C1') befinden, jeweils mit den seitlichen Anoden- und Kathodenflächen des Anodenkühlkörpers (61) und des Kathodenkühlkörpers (52), die durch eine kapazitive seitliche elektrische Verbindung (5261cp) miteinander verbunden sind und sich auf derselben Seite der dritten Zelle (C3`) befinden, durch leitfähige seitliche elektrische Verbindungen (2161c, 1252c) verbunden sind,
die seitlichen Anoden- und Kathodenflächen des Anodenkühlkörpers (31) und des Kathodenkühlkörpers (42), die durch eine kapazitive seitliche elektrische Verbindung (4231cp) miteinander verbunden sind und sich auf derselben Seite der zweiten Zelle (C2`) befinden, jeweils mit den seitlichen Anoden- und Kathodenflächen des Anodenkühlkörpers (71) und des Kathodenkühlkörpers (82), die durch eine kapazitive seitliche elektrische Verbindung (8271cp) miteinander verbunden sind und sich auf derselben Seite der vierten Zelle (C4`) befinden, durch leitfähige seitliche elektrische Verbindungen (3171c, 4282c) verbunden sind,
die seitlichen Anoden- und Kathodenflächen des Anodenkühlkörpers (41) und des Kathodenkühlkörpers (32), die durch eine leitfähige seitliche elektrische Verbindung (4132c) miteinander verbunden sind und sich auf derselben Seite der zweiten Zelle (C2`) befinden, jeweils mit den seitlichen Anoden- und Kathodenflächen des Anodenkühlkörpers (81) und des Kathodenkühlkörpers (72), die durch eine leitfähige seitliche elektrische Verbindung (8172c) miteinander verbunden sind und sich auf derselben Seite der vierten Zelle (C4`) befinden, durch isolierende seitliche elektrische Verbindungen (4181i, 3272i) verbunden sind,
so dass das System einen Leistungswandler vom verschachtelten Chopper-Typ bildet.

10. System nach einem der vorhergehenden Ansprüche, bei dem jeder Kühlkörper (11, 12, 21, 22) mindestens eines von einer Rippe und einem Finger umfasst.

11. System nach einem der vorhergehenden Ansprüche mit Ausnahme der Ansprüche 1, 5 und 9, bei dem mindestens eine der kapazitiven seitlichen elektrischen Verbindungen (1221cp, 2211cp, 6251cp, 4231cp) und der kapazitiven zentralen elektrischen Verbindung mindestens einen Kondensator (10cp) umfasst.

12. System nach einem der vorhergehenden Ansprüche, das ferner eine Kühlvorrichtung (2000) umfasst, die so eingerichtet ist, dass sie jeden Anoden- und Kathodenkühlkörper (11, 12, 21, 22) kühlt.

13. System nach einem der vorhergehenden Ansprüche, das ferner mindestens ein Elementarinduktivitätsmodul (9) umfasst, das Folgendes umfasst:
- Eine leitfähige Spule (900), die in eine magnetische Matrix (903) eingebettet ist und eine erste Fläche und eine zweite Fläche gegenüber der ersten Fläche aufweist,
- einen ersten elektrisch leitfähigen Kühlkörper (91) auf der ersten Fläche, der mit der leitfähigen Spule (900) verbunden ist, und
- einen zweiten elektrisch leitfähigen Kühlkörper (92) auf der zweiten Fläche, der mit der leitfähigen Spule (900) verbunden ist.

## Claims

1. An electronic system comprising at least one electronic cell (C0), said at least one electronic cell (C0) comprising:
- a first elementary power electronic module (1), called first elementary module (1),
- a second elementary power electronic module (2), called second elementary module (2),
said first and second elementary modules (1, 2) being adjacent and connected to each other by an electrical module connection,
each of these first and second elementary modules (1, 2) comprising:
- at least one power component (100, 200), preferably integrated on or in a printed circuit (10),
- a first electrically conductive heat sink (11, 21), called anode heatsink, connected to a first electrode called anode of the power component (100, 200), and
- a second electrically conductive heat sink (12, 22), called cathode heatsink, connected to a second electrode called cathode of the power component (100, 200),
in said electronic system,
each cathode heatsink (12, 22) has a first connection surface (120) called central cathode surface and at least one second connection surface (121, 122, 222) called cathode side surface, and
each anode heatsink (11, 21) has a first connection surface (110, 210) called central anode surface and at least one second connection surface (111, 112, 212) called anode side surface, and:
the electrical module connection between the first and second adjacent elementary modules (1, 2) comprises at least one conductive side electrical connection (1121c, 1222c) between:
at least one of the anode and cathode side surfaces (111, 121) of the first elementary module (1), and
at least one of the anode and cathode side surfaces (212, 222) of the second elementary module (2).

2. The system according to the preceding claim wherein the electrical module connection between the first and second adjacent elementary modules (1, 2) further comprises one of a capacitive side electrical connection (1222cp) and an insulating side electrical connection (1221i) between:
at least another one of the anode and cathode side surfaces (111, 121) of the first elementary module (1), and
at least another one of the anode and cathode side surfaces (212, 222) of the second elementary module (2).

3. The system according to the preceding claim wherein at least one anode side surface (111) of the first elementary module (1) is connected to at least one cathode side surface (222) of the second elementary module (2) by a conductive side electrical connection (1122c) and at least one cathode side surface (121) of the first elementary module (1) is connected to at least one anode side surface (212) of the second elementary module (2) by an electrical connection chosen from a capacitive side electrical connection (1221cp) and an insulating side electrical connection (1221i).

4. The system according to the preceding claim wherein the at least one power component (100) of the first elementary module (1) is one of a first power transistor and a first power diode, and the at least one power component (200) of the second elementary module (2) is one of a second power transistor and a second power diode, so that the electronic cell forms a switching cell (C10).

5. The system according to any one of the preceding claims comprising a plurality of adjacent electronic cells connected to each other, one electronic cell (C1, C1') of the plurality of electronic cells being connected to at least one adjacent electronic cell (C2, C2') by an electrical connection of cells, said electrical connection of cells comprising at least one of a conductive central electrical connection (1231c, 1242c), a capacitive central electrical connection and a central insulating electrical connection (2142i) between:
at least one of the central anode and cathode surfaces of the cell (C1, C1'), and
at least one of the central anode and cathode surfaces of the at least one cell (C2, C2') adjacent to said cell (C1, C1').

6. The system according to the preceding claim, wherein at least one central cathode surface (120) of the cell (C1) is connected to at least one central anode surface (310) of the adjacent cell (C2) by a conductive central electrical connection (1231c) and at least one central anode surface (210) of the cell (C1) is connected to at least one central cathode surface (420) of the adjacent cell (C2) by a central insulating electrical connection (2142i).

7. The system according to the preceding claim and claim 4 wherein each electronic cell (C1, C2, C3) of the plurality of electronic cells is a switching cell (C10), so that the system forms a sub-assembly of a multilevel power converter.

8. The system according to claim 5 wherein the electrical connection of cells further comprises at least one side conductive electrical connection (1252c, 2161c) between:
at least one of the anode and cathode side surfaces of the cell (C1'), and
at least one of the anode and cathode side surfaces of at least one other cell (C3') adjacent to said cell (C1').

9. The system according to the preceding claim and claim 4 comprising a first electronic cell (C1'), a second electronic cell (C2'), a third electronic cell (C3'), a fourth electronic cell (C4'), said first, second, third, fourth electronic cells (C1', C2', C3', C4') being switching cells (C10), wherein:
the central anode and cathode surfaces of the anode (21) and cathode (12) heat sinks connected to each other by a capacitive side electrical connection (1221cp) of the first cell (C1') are respectively connected to the central anode and cathode surfaces of the anode (31) and cathode (42) heat sinks connected to each other by a capacitive side electrical connection (4231cp) of the second cell (C2'), by conductive central electrical connections (2131c, 1242c),
the central anode and cathode surfaces of the anode (61) and cathode (52) heat sinks connected to each other by a capacitive side electrical connection (5261cp) of the third cell (C3') are respectively connected to the central anode and cathode surfaces of the anode (71) and cathode (82) heat sinks connected to each other by a capacitive side electrical connection (8271cp) of the fourth cell (C4'), by conductive central electrical connections (6171c, 5282c),
the anode and cathode side surfaces of the anode (11) and cathode (22) heat sinks connected to each other by a conductive side electrical connection (1122c), located on the same side of the first cell (C1') are respectively connected to the anode and cathode side surfaces of the anode (51) and cathode (62) heat sinks connected to each other by a conductive side electrical connection (5162c), located on the same side of the third cell (C3'), by insulating side electrical connections (1151i, 2262i),
the anode and cathode side surfaces of the anode (21) and cathode (12) heat sinks connected to each other by a capacitive side electrical connection (1221cp), located on the same side of the first cell (C1') are respectively connected to the anode and cathode side surfaces of the anode (61) and cathode (52) heat sinks connected to each other by a capacitive side electrical connection (5261cp), located on the same side of the third cell (C3'), by conductive side electrical connections (2161c, 1252c),
the anode and cathode side surfaces of the anode (31) and cathode (42) heat sinks connected to each other by a capacitive side electrical connection (4231cp), located on the same side of the second cell (C2') are respectively connected to the anode and cathode side surfaces of the anode (71) and cathode (82) heat sinks connected to each other by a capacitive side electrical connection (8271cp), located on the same side of the fourth cell (C4'), by conductive side electrical connections (3171c, 4282c),
the anode and cathode side surfaces of the anode (41) and cathode (32) heat sinks connected to each other by a conductive side electrical connection (4132c), located on the same side of the second cell (C2') are respectively connected to the anode and cathode side surfaces of the anode (81) and cathode (72) heat sinks connected to each other by a conductive side electrical connection (8172c), located on the same side of the fourth cell (C4'), by insulating side electrical connections (4181i, 3272i),
so that the system forms an interlaced chopper type power converter.

10. The system according to any one of the preceding claims, wherein each heatsink (11, 12, 21, 22) comprises at least one of a fin and a finger.

11. The system according to any one of the preceding claims with the exception of claims 1, 5 and 9 wherein at least one of the capacitive side electrical connection (1221cp, 2211cp, 6251cp, 4231cp) and the capacitive central electrical connection comprises at least one capacitor (10cp).

12. The system according to any one of the preceding claims further comprising a cooling device (2000) configured to cool each anode and cathode heat sink (11, 12, 21, 22).

13. The system according to any one of the preceding claims further comprising at least one elementary inductance module (9) comprising:
- a conductive coil (900) embedded in a magnetic matrix (903) having a first face and a second face opposite the first face,
- a first electrically conductive heat sink (91) on the first face and connected to said conductive coil (900), and
- a second electrically conductive heat sink (92) on the second face and connected to said conductive coil (900).
